# EUROPÄISCHE PATENTANMELDUNG

(11) **EP 3 487 271 A1**
(43) Veröffentlichungstag der Anmeldung: **22.05.2019**
(21) Anmeldenummer: 18204485.9
(22) Anmeldetag: 06.11.2018
(51) Int. Cl.: H05K 7/14

(54) **EINSCHUBGERÄT SOWIE BAUGRUPPENTRÄGER**

(30) Priorität: 16.11.2017 DE 202017106983 U
(71) Anmelder: MEN Mikro Elektronik GmbH, 90411 Nürnberg (DE)
(72) Erfinder: EICHNER, Jürgen, 90411 Nürnberg (DE)
(74) Vertreter: FDST Patentanwälte

(57) **Zusammenfassung**

Die Erfindung betrifft ein Einschubgerät (10) zur Montage in einem Baugruppenträger (2) mit einem Gehäuse (14) zur Aufnahme einer ersten elektronischen Baugruppe (16) mit einer ersten Frontplatte (20), wobei das Gehäuse (14) eine Bodenplatte (30) und eine dieser gegenüberliegend angeordnete Deckelplatte (28) sowie zwei hierzu quer angeordnete Seitenplatten (32) aufweist, und wobei die Seitenplatten (32) mit der Bodenplatte (30) und mit der Deckelplatte (28) mittels Fügekonturen (52) werkzeugfrei gefügt sind.

## Beschreibung

Die Erfindung betrifft ein Einschubgerät zur Montage in einem Baugruppenträger, mit einem Gehäuse zur Aufnahme einer elektronischen Baugruppe mit einer Frontplatte, wobei das Gehäuse eine Bodenplatte und eine dieser gegenüberliegend angeordneten Deckelplatte sowie zwei hierzu quer angeordnete Seitenplatten aufweist. Des Weiteren betrifft die Erfindung einen Baugruppenträger.

Ein solches Einschubgerät wird beispielsweise in einen Baugruppenträger (Einschub) montiert, welcher insbesondere eine auf 19-Zoll genormte Breite aufweist und in einem Gestell (Rack) mit entsprechender Breite aufgenommen wird. Insbesondere weist das Einschubgerät dabei eine genormte Breite auf, so dass weitere Einschubgeräte lückenlos benachbart zueinander in den Baugruppenträger aufgenommen werden können.

Das Einschubgerät weist ein Gehäuse auf, in welches eine elektronische Baugruppe aufgenommen ist. Das Gehäuse ist üblicherweise quaderförmig ausgeführt (geformt) und auf einer (Front-)Seite von einer Frontplatte der Baugruppe abgedeckt. Beispielsweise ist das Gehäuse mehrteilig ausgeführt. Insbesondere weist das Gehäuse eine Deckelplatte, eine Bodenplatte sowie zwei Seitenplatten auf, welche zusammen einen die Baugruppe umfassenden Mantel (Gehäusemantel) bilden. Die Platten des Mantels (Mantelplatten) werden dann beispielsweise miteinander verschraubt, so dass eine wiederlösbare und sichere Verbindung untereinander hergestellt ist, welche jedoch mit einem vergleichsweise hohen Arbeitsaufwand bei einer Erstmontage sowie im Zuge einer Demontage bei einer eventuell notwendigen Wartung verbunden ist.

Der Erfindung liegt die Aufgabe zugrunde, ein Einschubgerät anzugeben, welches mit möglichst geringem Aufwand montierbar ist. Zudem soll eine einfache Montage und Demontage einer elektronischen Baugruppe des Einschubgeräts ermöglicht sein. Des Weiteren soll ein Baugruppenträger zur Aufnahme eines solchen Einschubgeräts angegeben werden.

Bezüglich des Einschubgeräts wird diese Aufgabe erfindungsgemäß gelöst durch die Merkmale des Anspruchs 1 und bezüglich des Einschubgeräts wird die Aufgabe gelöst durch die Merkmale des Anspruchs 12. Vorteilhafte Weiterbildungen und Ausgestaltungen sind Gegenstand der Unteransprüche.

Hierzu umfasst das Einschubgerät, welches insbesondere zur Montage in einem Baugruppenträger vorgesehen ist, ein Gehäuse zur Aufnahme einer ersten elektronischen Baugruppe mit einer ersten Frontplatte auf. Das Gehäuse weist eine Bodenplatte und eine dieser gegenüberliegend angeordneten Deckelplatte sowie zwei hierzu quer angeordnete Seitenplatten auf. Dabei sind die Seitenplatten mit der Bodenplatte und mit der Deckelplatte mittels Fügekonturen werkzeugfrei gefügt.

Mit anderen Worten sind die Bodenplatte zur Deckelplatte und die beiden Seitenplatten zueinander jeweils parallel und beabstandet angeordnet. Die beiden Seitenplatten sind senkrecht zur Bodenplatte und zur Deckelplatte orientiert, wobei eine Seitenplatte jeweils mit der Bodenplatte und der Deckelplatte an deren Plattenkanten werkzeugfrei gefügt ist, so dass das Gehäuse im Wesentlichen quaderförmig ausgebildet ist.

Zusammenfassend ist mittels der Bodenplatte, der Deckelplatte und den Seitenplatten ein Mantel mit einer Mantelachse gebildet, welche senkrecht zu einer Seitenplattennormalen und senkrecht zu einer Bodenplattennormalen orientiert ist. Mit anderen Worten verläuft die Mantelachse senkrecht durch die beiden, im Folgenden als erste Mantelöffnung bzw. als zweite Mantelöffnung bezeichneten Seiten des Gehäuses, welche nicht durch die Bodenplatte, die Deckelplatte oder die Seitenplatten gebildet ist. Der Mantel weist einen im Wesentlichen rechteckigen Querschnitt in einer Ebene senkrecht zu Mantelachse auf. Die Bodenplatte, die Deckelplatte und die Seitenplatten werden zusammenfassend im Folgenden als Mantelplatten bezeichnet.

Das Gehäuse weist des Weiteren eine Rückplatte auf, welche die erste Mantelöffnung abdeckt. Die Rückplatte ist dabei am Mantel befestigt, wie beispielsweise verschraubt. An der dem Mantel abgewandten Seite der Rückplatte kann des Weiteren eine Kühlvorrichtung angebracht sein. Auf diese Weise wird Wärme abgeführt, welche insbesondere von einem innerhalb des Gehäuses und an der Rückplatte angeordnetem Bauelement, wie beispielsweise einer Vorrichtung zur Energieversorgung der Baugruppe (Netzteil), abgegeben wird. Die Kühlvorrichtung ist dabei beispielsweise als ein Kühlkörper mit vergleichsweise hoher Wärmeleitfähigkeit sowie beispielsweise mit einer Kamm - oder Lamellenform ausgeführt, so dass die vom Bauelement an den Kühlkörper zugeführte Wärme über eine vergleichsweise große Oberfläche an dessen Umgebungsluft abgeführt und somit das Bauelement gekühlt wird. Alternativ erfolgt die Kühlung mittels einer mittels eines elektrischen Stroms betriebenen (aktiven), insbesondere nach Art eines Kühlerlüfters ausgebildeten, Kühlvorrichtung.

Vorzugsweise ist das Gehäuse aus Aluminium hergestellt und passiviert. Eine Korrosion des Gehäuses ist somit vorteilhaft vermieden. Vorzugsweise ist das Gehäuse dabei derart passiviert, dass das Gehäuse elektrisch leitfähig ist. Auf diese Weise sind vorteilhaft die Gehäusebestandteile, insbesondere die Platten, des Gehäuses vergleichsweise einfach auf ein gemeinsames elektrisches Potential, insbesondere ein Bezugspotential wie beispielsweise ein elektrisches Nullpotential, führbar bzw. geführt oder erdbar bzw. geerdet. Hierzu wird beispielsweise eine sog. Chrom(VI)-freie Passivierung herangezogen.

In der ersten Frontplatte sind beispielsweise eine Anzeige und/oder ein Stellelement, wie beispielsweise ein Hebel oder ein Drehregler und/oder ein Anschluss zur Kontaktierung der elektrischen Baugruppe angeordnet. Die Frontplatte ist am Mantel des Gehäuses, insbesondere mittels einer Schraube, befestigt und deckt die zweite Mantelöffnung ab.

Aufgrund des werkzeugfreien Fügens der Bodenplatte, der Deckelplatte sowie der Seitenplatten ist besonders vorteilhaft eine vergleichsweise einfache und schnelle Montage und/oder Demontage des Mantels ermöglicht.

Hierzu weisen gemäß einer vorteilhaften Weiterbildung die Deckelplatte und die Bodenplatte Fügestege als Fügekonturen auf, welche in als Fügenuten ausgebildete Fügekonturen der Seitenplatten nach Art einer Spundung aufgenommen sind. Die Fügestege sowie die Fügenuten weisen dabei vorzugsweise einen rechteckigen Querschnitt auf, so dass die Mantelplatten mittels einer besonders einfach herzustellenden Steckverbindung zwischen den Mantelplatten werkzeugfrei gefügt sind.

Bei dieser Ausführung ist die Rückplatte vorzugsweise an jeder der Mantelplatten befestigt, so dass das Gehäuse stabil gegenüber einem Verstellen, wie beispielsweise einem Verschieben, der Mantelplatten ist. Vorzugsweise wird die erste Frontplatte an zumindest zwei der Mantelplatten befestigt, so dass das Gehäuse zusätzlich stabilisiert ist.

In einer alternativen Ausführung sind die Fügekonturen beispielsweise als Fügezapfen und dazu korrespondierende Zapfenaufnahmen zur Ausbildung einer Steckverbindung ausgebildet. Gemäß einer weiteren Alternative weisen die Fügenuten und Fügestege jeweils einen im Wesentlichen T-förmigen Querschnitt in einer Ebene senkrecht zur Mantelachse auf, so dass die Mantelplatten mittels einer Schiebeverbindung formschlüssig bezüglich einer Richtung senkrecht zur Mantelachse miteinander gefügt sind. Allenfalls ist mittels der Fügekonturen eine wiederlösbare Verbindung der Mantelplatten miteinander realisiert.

Gemäß einer zweckmäßigen Weiterbildung ist in das Gehäuse eine zweite elektronische Baugruppe mit einer zweiten Frontplatte einbringbar oder eingebracht. Dabei sind die erste Frontplatte der ersten elektronischen Baugruppe und die zweite Frontplatte der zweiten elektronischen Baugruppe benachbart zueinander anordenbar bzw. angeordnet. Mit anderen Worten kann das Gehäuse zwei elektronische Baugruppen umfassen bzw. umfasst diese. Unter benachbart wird hier verstanden, dass die erste Frontplatte und die zweite Frontplatte in einer durch die erste Frontplatte aufgespannten Ebene und vorzugsweise in Richtung der Seitenplattennormalen nebeneinander anordenbar bzw. angeordnet sind. Sofern keine zweite Baugruppe in das Einschubgerät eingebracht ist und die erste Frontplatte nicht die gesamte zweite Mantelöffnung überdeckt, ist der nicht mittels der ersten Frontplatte abgedeckte Teil der zweiten Mantelöffnung beispielsweise mittels einer Blende versehen.

Die zweite Frontplatte bzw. die Blende ist vorzugsweise an mindestens zwei der Mantelplatten befestigt, so dass das Gehäuse zusätzlich stabilisiert ist. Die zweite Frontplatte weist analog zur ersten Frontplatte eine Anzeige, ein Stellelement und/oder einen Anschluss zur Kontaktierung der zweiten Baugruppe auf.

Gemäß einer vorteilhaften Weiterbildung überlappen die erste Frontplatte und die zweite Frontplatte entlang deren benachbarten Stirnseiten. Mit anderen Worten ist eine Überlappverbindung zwischen der ersten Frontplatte und der zweiten Frontplatte beispielsweise nach Art einer kleberfreien Schäftung hergestellt, vorzugsweise sind dabei die sich überlappenden Stirnseiten falzartig ausgebildet. Aufgrund der Überlappung ist ein Eindringen oder Austreten elektromagnetischer Strahlung in das Gehäuse bzw. aus dem Gehäuse durch einen zwischen der ersten Frontplatte und der zweiten Frontplatte gebildeten Spalt besonders vorteilhaft vermieden. Somit ist eine elektromagnetische Verträglichkeit (EMV) des Einschubgeräts ohne zusätzliche Elemente, wie beispielsweise einer Feder oder Dichtung, vorteilhaft verbessert.

Gemäß einer vorteilhaften Ausführung weisen die Seitenplatten in einer zu der ersten Frontplatte parallelen Ebene eine U-förmige Querschnittsform mit zwei zu der Deckelplatte parallel orientierten U-Schenkeln und einem die beiden U-Schenkel verbindenden Verbindungsschenkel (U-Verbindungsschenkel) auf. Dabei sind die U-Schenkel der Seitenplatten einander zugewandt, d.h. die U-Schenkel einer Seitenplatte sind derart orientiert, dass sich diese jeweils vom Verbindungsschenkel zur anderen Seitenplatte hin erstrecken.

Gemäß einer zweckmäßigen Weiterbildung sind die Fügenuten in den freiendseitigen Stirnseiten der U-Schenkel eingebracht. Unter der freiendseitigen Stirnseite ist dabei die vom Verbindungsschenkel abgewandte Seite des U-Schenkels zu verstehen.

Gemäß einer vorteilhaften Ausführung sind an den einander zugewandten Seiten der U-Schenkel Haltekonturen zur Halterung der ersten elektronischen Baugruppe bzw. der zweiten elektronischen Baugruppe angeordnet. Insbesondere ist die Haltekontur als eine Haltenut ausgebildet, in welche beispielsweise eine Leiterkarte oder ein an der Leiterkarte angeordnetes Halteelement der ersten elektronischen Baugruppe bzw. der zweiten elektronischen Baugruppe aufgenommen und gehalten ist. Im Zuge der Montage wird dann beispielsweise die Leiterkarte auf vergleichsweise einfache Art der schiebe- oder steckverbunden.

Gemäß einer zweckmäßigen Weiterbildung sind die Seitenplatten mittels Strangpressen hergestellt. Insbesondere sind durch das Strangpressen die U-Form der Seitenplatten sowie die Fügekonturen und die Haltekonturen vergleichsweise einfach realisiert. Zusätzlich sind ebenfalls die Bodenplatte sowie die Deckelplatte mittels Strangpressen hergestellt. Alternativ sind die Bodenplatte sowie die Deckelplatte als ein Blech ausgeführt, welches eine Dicke in Richtung der Plattennormalen derart aufweist, dass das Blech in die Fügenuten der Seitenplatten einsteckbar ist.

Beispielsweise sind die beiden Seitenplatten formgleich ausgeführt, weshalb eine Herstellung der beiden Seitenplatten - quasi als Gleichteile - vergleichsweise einfach und kostengünstig ist. Analoger Weise sind ebenfalls die Bodenplatte und die Deckelplatte formgleich bzw. als Gleichteile ausgeführt.

Innerhalb des Gehäuses ist parallel zur ersten Frontplatte eine Leiterplatte, insbesondere eine Busplatine (Backplane) angeordnet, welche mit ersten elektronischen Baugruppe und/oder der zweiten elektronischen Baugruppe gekoppelt ist. Insbesondere wird unter "gekoppelt" hier "als elektrisch und mechanisch miteinander verbunden" verstanden. Dazu weist die Leiterplatte beispielsweise Steckelemente auf, auf welche die Leiterkarte der ersten elektronischen Baugruppe und/oder der zweiten elektronischen Baugruppe aufgesteckt werden, so dass eine elektrische Verbindung zwischen den aufgesteckten Baugruppen ermöglicht ist.

Gemäß einer vorteilhaften Weiterbildung ist die Leiterplatte formschlüssig an der Bodenplatte oder an der Deckelplatte, vorzugsweise an der Bodenplatte und an der Deckelplatte, gehalten. Hierzu ist beispielsweise an der Leiterplatte eine Fügelippe angeformt, welche im Zuge der Montage in eine korrespondierende Aussparung in der Bodenplatte und/oder der Deckelplatte eingesteckt wird bzw. eingreift. Somit ist die Leiterplatte werkzeugfrei und mittels einer Steckverbindung innerhalb am Mantel des Gehäuses angebracht.

Gemäß einer vorteilhaften Weiterbildung sind die erste elektronische Baugruppe und/oder die zweite elektronische Baugruppe entlang einer Montagerichtung, welche parallel zur Seitenplattennormale orientiert ist, mit der Leiterplatte mechanisch lösbar gefügt sind. Mit anderen Worten erfolgt das Fügen in einer zur Leiterplatte parallel verlaufenden Montagerichtung. Auf diese Weise ist eine wiederlösbare mechanische Verbindung zur Halterung der entsprechenden elektronischen Baugruppe an der Leitplatte hergestellt, wobei die Verbindung zum Zwecke einer einfachen Montage vorzugsweise als Steckverbindung ausgeführt ist.

Hierzu weist die Leiterplatte beispielsweise einen sich in Richtung der Seitenplattennormalen erstreckenden angeformten Fügefortsatz auf, welcher in eine korrespondierende Fortsatzaufnahme der elektronischen Baugruppe, insbesondere dessen Leiterkarte, aufgenommen ist. Vorteilhaft sind auf diese die erste elektronische Baugruppe bzw. die zweite elektronische Baugruppe formschlüssig und sicher entlang der Mantelachse gehalten und eine vergleichsweise einfache und schnelle seitliche, d.h. in Richtung der Seitenplattennormalen, Montage und Demontage der entsprechenden Baugruppe ermöglicht.

Ein Einschubgerät in einer der oben beschriebenen Varianten ist gemäß einer zweckmäßigen Ausgestaltung in einem Einschubfach eines Baugruppenträgers (Einschub) aufgenommen. Der Baugruppenträger weist insbesondere eine genormte Breite von 19-Zoll, was 84 sogenannten Teilungseinheiten (jeweils 0,2 Zoll) entspricht, und eine Höhe von eines Einfachen oder eines Vielfachen einer sogenannten Höheneinheit (jeweils 1,75 Zoll) auf. Dieser ist beispielsweise in einem entsprechenden Gestell (Rack) oder einem Schaltschrank montiert. Das Einschubgerät weist eine zur Befestigung im Baugruppenträger entsprechende Höhe und eine Breite von insbesondere 21 Teilungseinheiten, also einem Viertel der gesamten Breite von 19-Zoll, auf, so dass auf platzsparende Weise weitere Einschubgeräte lückenlos benachbart zueinander in den Baugruppenträger aufgenommen werden können.

Nachfolgend wird ein Ausführungsbeispiel der Erfindung anhand einer Zeichnung näher erläutert. Darin zeigen:
- Fig. 1: in perspektivischer Darstellung ein in einem Baugruppenträger aufgenommenes Einschubgerät mit einem Gehäuse, in welches eine erste elektronische Baugruppe und eine zweite elektronische Baugruppe aufgenommen sind,
- Fig. 2: in perspektivischer Explosionsdarstellung gemäß Fig.1 eine Deckelplatte und eine Seitenplatte des Einschubgeräts sowie eine auf eine Busplatine aufgesteckte Leiterkarte der zweiten Baugruppe und ein Netzteil, welches an eine Kühlstruktur einer Rückplatte thermisch angeschlossen ist,
- Fig. 3: in vergrößertem Maßstab gemäß dem Bereich III der Fig. 1 die Seitenplatte mit einer Fügekontur und mit einer Führungsnut sowie mit einem Schraubkanal, wobei die Seitenplatte eine gestufte U-Form bildet,
- Fig. 4: in perspektivischer Rückansicht das Einschubgerät mit demontierter zweiter Baugruppe mit Blick auf die Busplatine mit einem Steckzapfen zum Aufstecken der Leiterkarte der zweiten Baugruppe sowie mit in Aussparungen der Bodenplatte und der Deckelplatte eingesteckten Fixierzapfen,
- Fig. 5: in einer Rückansicht die beiden Seitenplatten, wobei jede der beiden Seitenplatten mittels jeweils einer Spundung mit einer Bodenplatte und der Deckelplatte gefügt ist, und eine in der Führungsnut der entsprechenden Seitenplatte gehaltene Leiterkarte der ersten Baugruppe, und
- Fig. 6: den Bereich VII gemäß Fig. 1 in vergrößertem Maßstab mit einer ersten Frontplatte der ersten elektronischen Baugruppe, welche mit einer zweiten Frontplatte der zweiten elektronischen Baugruppe eine Überlappverbindung bildet.

Einander entsprechende Teile sind in allen Figuren mit den gleichen Bezugszeichen versehen.

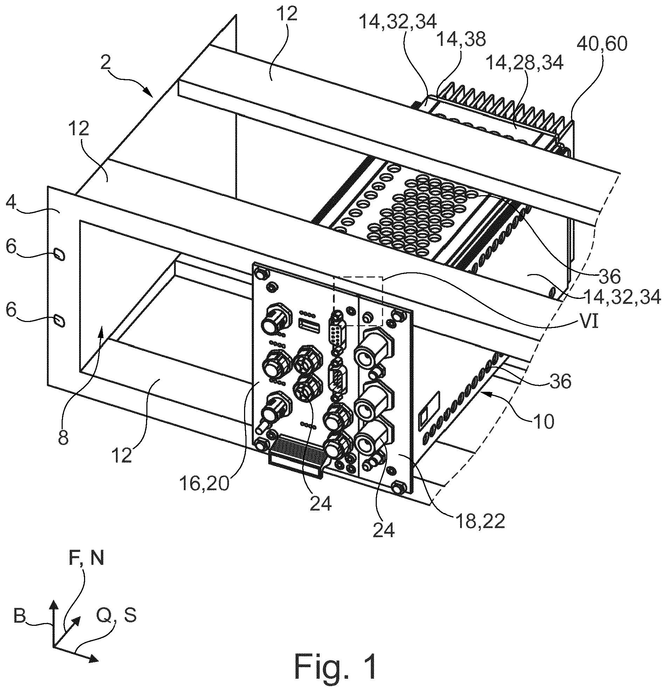

In Fig. 1 ist ansatzweise und schematisch ein Baugruppenträger 2 mit einer auf 19-Zoll genormten Breite und mit einer Höhe von drei sogenannten Höheneinheiten, d.h. insgesamt 5,25 Zoll dargestellt. Der Baugruppenträger 2 weist eine Trägerfrontplatte 4 auf, in welche Aussparungen 6 insbesondere zur Schraubmontage an einem nicht weiter dargestelltem Gestell (Rack) eingebracht sind. Des Weiteren weist der Baugruppenträger 2 ein Einschubfach 8 auf, in welches ein Einschubgerät 10 aufgenommen ist. Das Einschubgerät 10 wird dabei mittels sich in einer Querrichtung Q erstreckenden Streben 12 gehalten. Die Querrichtung Q ist dabei - bei einer bestimmungsgemäßen Montage des Baugruppenträgers 2 - parallel zu einem Untergrund und senkrecht zu einer Normalen N der Trägerfrontplatte 4.

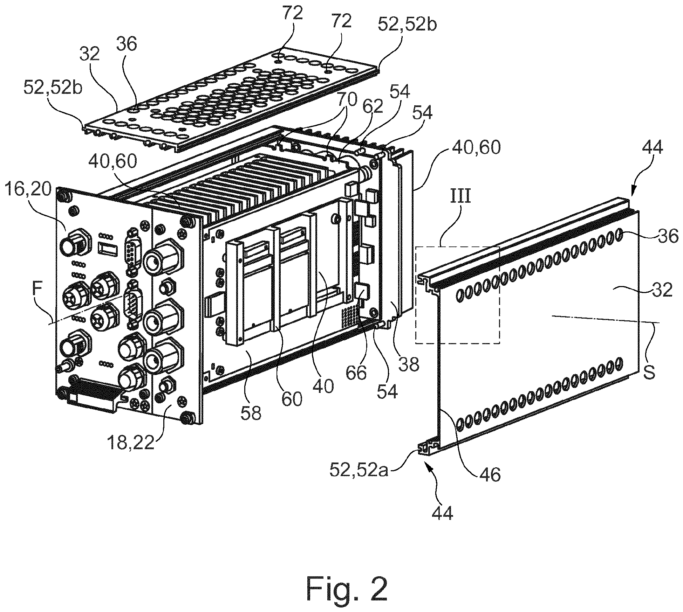

Das Einschubgerät 10 weist ein Gehäuse 14 auf, in welches eine erste elektronische Baugruppe 16 sowie eine zweite elektronische Baugruppe 18 aufgenommen ist (Fig. 2). Mit anderen Worten umfasst das Gehäuse 14 die beiden Baugruppen 16 und 18. Die beiden Baugruppen 16 und 18 weisen eine erste Frontplatte 20 bzw. eine zweite Frontplatte 22 auf, in welchen Anschlüsse 24 zur Kontaktierung der Baugruppen 16 und 18 angeordnet sind, wobei zum Zwecke einer verbesserten Übersicht lediglich jeweils ein Anschluss 24 der Frontplatten 20 bzw. 22 mit einem Bezugszeichen versehen ist. Die beiden Frontplatten 20 und 22 sind dabei benachbart zueinander angeordnet und am Gehäuse 14 befestigt, so dass das Gehäuse 14 in einer Richtung entlang der Normalen N der Trägerfrontplatte 2 mittels der beiden Frontplatten 20 und 22 abgedeckt ist. Die Normale N der Trägerfrontplatte ist im bestimmungsgemäßen Montagezustand parallel zu einer Normalen F der ersten Frontplatte 20.

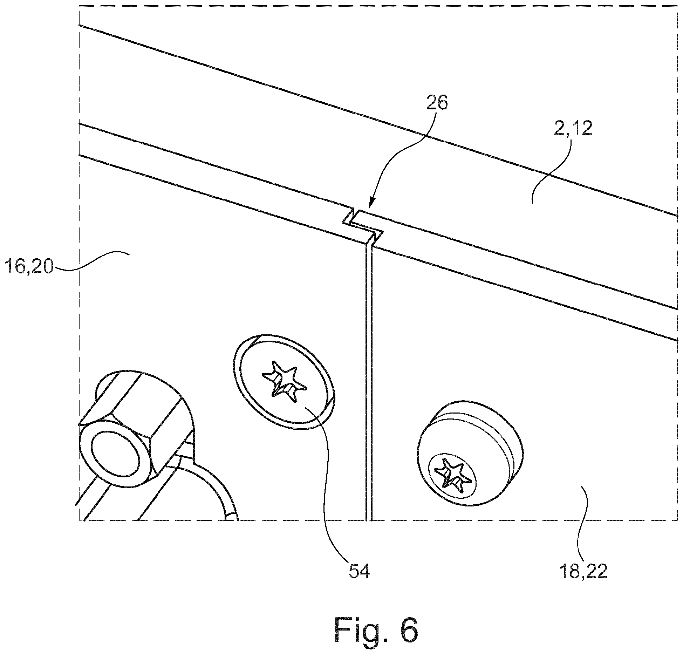

Die beiden Frontplatten 20 und 22 sind in einer Ebene parallel zur Trägerfrontplatte 4 und bezüglich der Querrichtung Q nebeneinander angeordnet. Wie in der Fig. 6 in vergrößertem Maßstab gezeigt ist, überlappen sich die beiden Frontplatten 20 und 22 entlang deren sich einander zugewandten Stirnseiten. Hierzu sind die Frontplatten 20 und 22 jeweils im Bereich dieser Stirnseiten stufenförmig (falzartig) ausgebildet und bilden eine Überlappverbindung 26, so dass eine elektromagnetische Verträglichkeit (EMV) ohne die Verwendung einer zwischen den Stirnseiten angeordneten Feder oder einer Dichtung gegeben bzw. verbessert ist.

In einer alternativen, nicht weiter dargestellten Ausführung ist lediglich eine der elektronischen Baugruppen 16 oder 18 im Gehäuse 14 aufgenommen. Eine Blende ist dann zu der Frontplatte 20 oder 22 der im Gehäuse 14 aufgenommenen Baugruppe benachbart am Gehäuse 14 befestigt und überlappt mit dieser vorzugsweise, so dass das Gehäuse 14 verschlossen ist und eine elektromagnetische Verträglichkeit verbessert ist. Alternativ ist das Gehäuse 14 mittels einer einzigen Frontplatte 20 bzw. 22 verschlossen, so dass eine zusätzliche Blende nicht notwendig ist. Mit anderen Worten deckt dann die Frontplatte 20 bzw. 22 der in das Gehäuse 14 eingebrachten elektronischen Baugruppe 16 oder 18 das Gehäuse 14 ab. Sofern beide elektronische Baugruppe 16 und 18 in das Gehäuse 14 eingebracht sind, ist gemäß dieser alternativen Ausführung diese einzige Frontplatte 20 bzw. 22 den in das Gehäuse 14 eingebrachten elektronischen Baugruppen 16 und 18 gemeinsam.

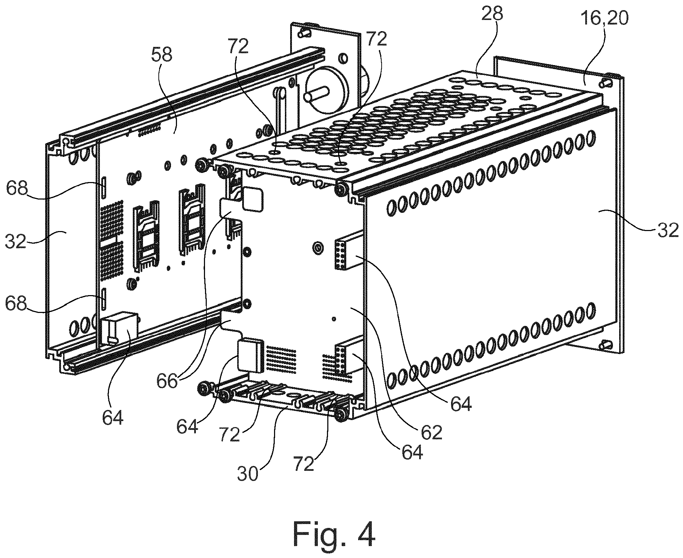

Das Gehäuse weist eine rechteckige Deckelplatte 28 und eine rechteckige Bodenplatte 30 (Fig. 4) auf, welche auf der dem Untergrund abgewandten bzw. zugewandten Seite des Gehäuses 14 angeordnet ist. Die Deckelplatte 28 und die Bodenplatte 30 sind an gegenüberliegenden Seiten des Gehäuses 14 angeordnet und zueinander parallel sowie beabstandet orienteiert. Zudem weist das Gehäuse 14 zwei zueinander parallele und beabstandete Seitenplatten 32 auf, welche senkrecht zur Bodenplatte 30 bzw. zur Deckelplatte 28 angeordnet sind, d.h. eine Seitenplattennormale S verläuft parallel zur Querrichtung Q. Die Deckelplatte 28, die Bodenplatte 30 und die beiden Seitenplatten 32 bilden zusammen einen die elektronischen Baugruppen 16 und 18 umfassenden Mantel und werden aufgrund dessen im Folgenden zusammenfassend als Mantelplatten 34 bezeichnet.

Die Mantelplatten 34 weisen kreisförmige Lüftungslöcher 36 auf, wodurch ein Durchströmen von Luft durch das Gehäuse 14 und somit ein Wärmeabtransport aus dem Gehäuse 14 mittels der Luft ermöglicht ist.

Des Weiteren weist das Gehäuse 14 eine Rückplatte 38 auf, welche auf der den beiden Frontplatten 20 und 22 abgewandten Seite des Mantels angeordnet und befestigt ist. Zusammenfassend ist das Gehäuse 14 quaderförmig.

Mittels eines an einer Außenseite der Rückplatte 38 angebrachten Kühlkörpers 40 wird eine im Gehäuse und an der Rückplatte angeordnete weitere Baugruppe 42 (Netzteil), welche zum Zwecke einer Energiebereitstellung ausgebildet ist, weiter gekühlt (Fig. 2).

Fig. 2 zeigt das Einschubgerät 10 in einer Explosionsdarstellung, wobei leidgleich die Bodenplatte 30 sowie die zur zweiten elektronischen Baugruppe 18 benachbart angeordnete (zugeordnete) Seitenplatte 32 als Einzelteile dargestellt sind. Die Seitenplatten 32 sind im Wesentlichen U-Förmig mit zwei zu der Deckelplatte 28 parallelorientierten U-Schenkeln 44 sowie mit einem die U-Schenkel 44 verbindenden Verbindungsschenkel (U-Verbindungsschenkel) 46 ausgeführt, wobei die U-Schenkel 44 auf der der Deckelplatte 28 zugewandten Seite des U-Verbindungsschenkels 46 angeordnet sind. Mit anderen Worten weisen die Seitenplatten in einer Ebene parallel zur ersten Frontplatte 20 einen im Wesentlichen U-förmigen Querschnitt auf, wobei die U-Schenkel 44 der beiden Seitenplatten 32 einander zugewandt sind, d.h. die freiendseitigen Stirnseiten der U-Schenkel 44 einer Seitenplatte 32 sind den freiendseitigen Stirnseiten der U-Schenkel 44 der anderen Seitenplatte 32 zugewandt.

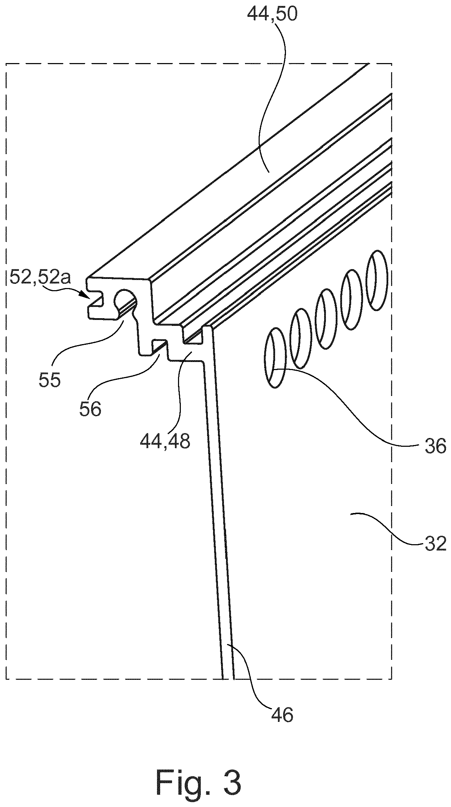

Wie in Fig. 3 im Vergrößertem Maßstab dargestellt ist, sind die U-Schenkel 44 des Weiteren unter Bildung zweier Schenkelbereiche 48 und 50 zu einem Außenbereich des Einschubgeräts 10 hin gestuft ausgebildet, wobei der erste Schenkelbereich 48 an den U- Verbindungsschenkel 46 angebunden ist. Zusammenfassend weisen die U-Schenkel 44 im Querschnitt eine Stufenform auf.

In den freiendseitigen Stirnseiten der U-Schenkel 44, d.h. jeweils an der dem U-Verbindungsschenkel 46 abgewandten Stirnseite eines U-Schenkels 44 bzw. des zweiten Schenkelbereichs 50, weisen die U-Schenkel 44 eine als Fügenut 52a ausgebildete Fügekontur 52 auf. In diese Fügenuten 52a ist im Montagezustand jeweils eine als Fügesteg 52b ausgebildete Fügekontur 52 der entsprechend zugeordneten Bodenplatte 30 bzw. Deckelplatte 28 nach Art einer Spundung aufgenommen. Somit sind die Seitenplatten 32 jeweils mit der Bodenplatte 30 und mit der Deckelplatte 28 werkzeugfrei durch eine Steckmontage miteinander gefügt.

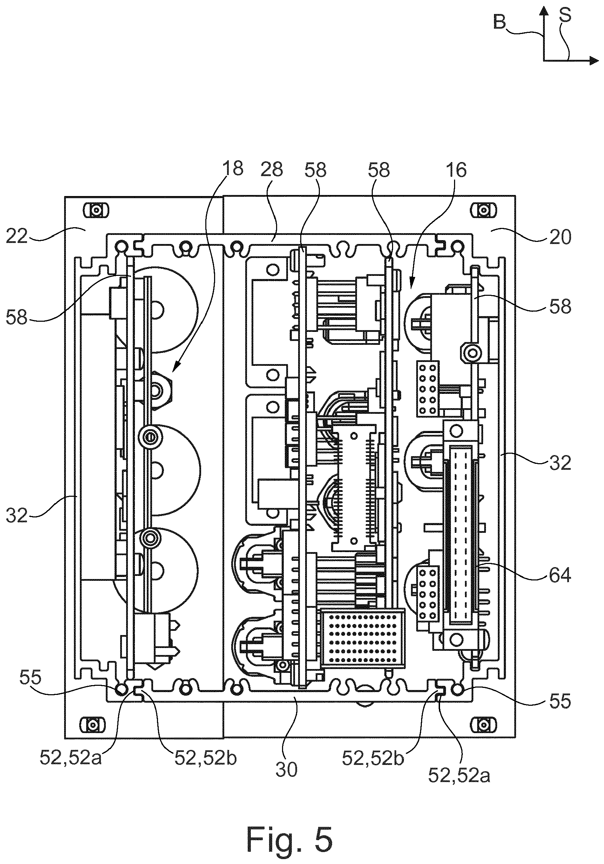

In Fig. 5 sind in einer Rückansicht die werkzeugfrei gefügten Mantelplatten 34 dargestellt, wobei die Frontplatten 20 und 22 der beiden elektronischen Baugruppen 16 und 18 mit der jeweils zugeordneten Seitenplatte 32 sowie mit der Bodenplatte 30 und der Deckelplatte 32 miteinander mittels Schraubelementen 54 verschraubt sind. Das Gehäuse 14 ist ferner durch eine Montage der Rückplatte 38 mittels Schraubelementen 54 an den Mantelplatten 34 stabilisiert. Hierzu sind an den Seitenplatten 34 nutenförmige Schraubkanäle 55 monolithisch angeformt, welche sich entlang der Normalen F der ersten Frontplatte 20 erstrecken. Diese weisen dabei in einer Ebene parallel zur ersten Frontplatte 20 einen Querschnitt mit einem die Schraubelemente 54 aufnehmenden, im Wesentlichen kreisförmigen Bereich auf, welcher nutenendseitig, d.h. an dem einer Oberfläche, mit weleher der nutenförmige Schraubkanal 55 verbunden ist, abgewandten Nutenende angeordnet ist. Der kreisförmige Bereich der Schraubkanäle 55 weist dabei einen Durchmesser derart auf und ist insbesondere aufgrund einer zumindest geringfügigen Verformbarkeit dessen dazu geeignet, dass auch nicht gewindefurchende Schraubelemente 54 aufgenommen werden können.

Wie insbesondere in den Figuren 3 und 5 erkennbar ist, sind an den Seitenplatten 32 jeweils an den einander zugewandten Seiten deren U-Schenkel 44 eine nutenförmige Haltekontur 56 angeordnet. Eine Leiterkarte 58 der ersten elektronischen Baugruppe 16 ist in die Haltekonturen 56 der entsprechenden Seitenplatte 32 aufgenommen, so dass die erste elektronische Baugruppe 16 mittels der Haltekonturen 56 gehalten ist.

Die Seitenplatten 32 sind dabei mittels Strangpressens hergestellt. Auf diese Weise sind die Haltekonturen 56, die Schraubkanäle 55, die Fügekonturen 52 sowie die gestufte U-Form vergleichsweise einfach realisiert.

Des Weiteren ist in der Fig. 2 gezeigt, dass den Leiterkarten 58 der ersten elektronischen Baugruppe 16 sowie der Leiterkarte 58 der zweiten elektronischen Baugruppe 18 jeweils ein kammförmiger Kühlköper 40 zugeordnet ist. Deren Zinken 60 sind dabei parallel zur ersten Frontplatte 20 orientiert, so dass durch die Lüftungslöcher 36 in das Gehäuse 14 einströmende Luft die Zinken 60 der kammförmigen Kühlköper 40 einfach überströmt und somit ein effizienter Wärmeabtransport realisiert ist.

Fig. 4 zeigt eine parallel zur ersten Frontplatte 20 angeordnete Leiterplatte 62, welche mit den beiden elektronischen Baugruppen 16 und 18 sowie mit der weiteren Baugruppe 42 gekoppelt ist. Mit anderen Worten weisen die weitere Baugruppe 42, die beiden elektronischen Baugruppen 16 und 18 sowie die Leiterplatte 62 zueinander korrespondierende Steckelemente 64 auf, so dass die eine wiederlösbare elektrische Verbindung sowie eine Steckverbindung hergestellt sind. Dabei ist die zweite elektronische Baugruppe 18 entlang einer parallel zur Seitenplattennormalen S orientierten Montagerichtung mit der Leiterplatte 62 mechanisch lösbar gefügt. Hierzu weist die Leiterplatte 62 einen sich in Richtung der Seitenplattennormalen S erstreckenden monolithisch angeformten Fügefortsatz 66 auf, welcher in eine korrespondierende Fortsatzaufnahme 68 der Leiterkarte 58 der zweiten elektronischen Baugruppe 18 aufgenommen ist. Mit anderen Worten ist die Leiterkarte 58 der zweiten elektronischen Baugruppe 18 mittels einer Steckverbindung formschlüssig bezüglich einer Richtung entlang der Normalen N der Trägerfrontplatte 4 sowie bezüglich einer Richtung entlang einer Bodenplattennormalen B stabil gehalten.

Auf diese Weise ist die zweite elektronische Baugruppe 18 im Zuge einer Montage und/oder einer Demontage seitlich, d.h. in Richtung der Seitenplattennormalen S abnehmbar, und ein Zugang zu den im Gehäuse 14 angeordneten Komponenten des Einschubgeräts 10 ist erleichtert. Die derart demontierte zweite Baugruppe 18 ist in Fig. 4 dargestellt.

Wie in der Figuren 2 vergleichsweise gut erkennbar ist, ist zudem die Leiterplatte 62 werkzeugfrei montierbar und mittels einer weiteren Steckverbindung formschlüssig an der Bodenplatte 30 sowie an der Deckelplatte 28 gehalten. Dazu sind an die Leiterplatte 62 an deren der Bodenplatte 30 und der Deckelplatte 28 zugewandten Stirnseite jeweils zwei Fügelippen 70 angeformt, welche in korrespondierende Aussparungen 72 der Bodenplatte 30 bzw. der Deckelplatte 28 eingreifen.

Die Erfindung ist nicht auf das vorstehend beschriebene Ausführungsbeispiel beschränkt. Vielmehr können auch andere Varianten der Erfindung vom Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

### Bezugszeichenliste

- 2: Baugruppenträger
- 4: Trägerfrontplatte
- 6: Aussparung
- 8: Einschubfach
- 10: Einschubgerät
- 12: Strebe
- 14: Gehäuse
- 16: erste elektronische Baugruppe
- 18: zweite elektronische Baugruppe
- 20: erste Frontplatte
- 22: zweite Frontplatte
- 24: Anschluss
- 26: Überlappverbindung
- 28: Deckelplatte
- 30: Bodenplatte
- 32: Seitenplatte
- 34: Mantelplatte
- 36: Lüftungsloch
- 38: Rückplatte
- 40: Kühlkörper
- 42: weitere Baugruppe
- 44: U-Schenkel
- 46: U-Verbindungsschenkel
- 48: erste Schenkelbereich
- 50: zweite Schenkelbereich
- 52: Fügekontur
- 52a: Fügenut
- 52b: Fügesteg
- 54: Schraubelement
- 55: Schraubkanal
- 56: Haltekontur
- 58: Leiterkarte
- 60: Zinke
- 62: Leiterplatte
- 64: Steckelemente
- 66: Fügefortsatz
- 68: Fortsatzaufnahme

- B: Bodenplattennormale
- F: Normale der ersten Frontplatte
- N: Normale der Trägerfrontplatte
- Q: Querrichtung
- S: Seitenplattennormale

## Patentansprüche

1. Einschubgerät (10) zur Montage in einem Baugruppenträger (2), aufweisend ein Gehäuse (14) zur Aufnahme einer ersten elektronischen Baugruppe (16) mit einer ersten Frontplatte (20),
- wobei das Gehäuse (14) eine Bodenplatte (30) und eine dieser gegenüberliegend angeordnete Deckelplatte (28) sowie zwei hierzu quer angeordnete Seitenplatten (32) aufweist, und
- wobei die Seitenplatten (32) mit der Bodenplatte (30) und mit der Deckelplatte (28) mittels Fügekonturen (52) werkzeugfrei gefügt sind.

2. Einschubgerät (10) nach Anspruch 1,
**dadurch gekennzeichnet,**
**dass** die Deckelplatte (28) und die Bodenplatte (30) Fügestege (52b) als Fügekonturen aufweisen, welche in als Fügenuten (52a) ausgebildete Fügekonturen der Seitenplatten (32) nach Art einer Spundung aufgenommen sind.

3. Einschubgerät (10) nach Anspruche 1 oder 2,
**dadurch gekennzeichnet,**
**dass** in das Gehäuse (14) eine zweite elektronische Baugruppe (18) mit einer zweiten Frontplatte (22) einbringbar oder eingebracht ist, wobei die erste Frontplatte (20) der ersten elektronischen Baugruppe (16) und die zweite Frontplatte (22) der zweiten elektronischen Baugruppe (18) benachbart zueinander anordenbar bzw. angeordnet sind.

4. Einschubgerät (10) nach Anspruch 3,
**dadurch gekennzeichnet,**
**dass** die erste Frontplatte (20) und die zweite Frontplatte (22) entlang deren benachbarten Stirnseiten überlappen.

5. Einschubgerät (10) nach einem der Ansprüche 1 bis 4,
**dadurch gekennzeichnet,**
**dass** die Seitenplatten (32) in einer zu der ersten Frontplatte (20) parallelen Ebene eine U-förmige Querschnittsform mit zwei zu der Deckelplatte (28) parallel orientierten U-Schenkeln (44) und mit einem Verbindungsschenkel (46) aufweisen, wobei die U-Schenkel (44) der Seitenplatten (32) einander zugewandt sind.

6. Einschubgerät (10) nach Anspruch 5,
**dadurch gekennzeichnet,**
**dass** die Fügenuten (52) in den freiendseitigen Stirnseiten der U-Schenkel (44) eingebracht sind.

7. Einschubgerät (10) nach Anspruch 5 oder 6,
**dadurch gekennzeichnet,**
**dass** an den einander zugewandten Seiten der U-Schenkel (44) Haltekonturen (56) zur Halterung der ersten elektronischen Baugruppe (16) bzw. der zweiten elektronischen Baugruppe (18) angeordnet sind.

8. Einschubgerät (10) nach einem der Ansprüche 1 bis 7,
**dadurch gekennzeichnet,**
**dass** die Seitenplatten (32) mittels Strangpressens hergestellt sind.

9. Einschubgerät (10) nach einem der vorhergehenden Ansprüche,
**dadurch gekennzeichnet,**
**dass** parallel zu der ersten Frontplatte (20) eine Leiterplatte (62) angeordnet ist, welche mit der ersten elektronischen Baugruppe (16) und/oder der zweiten elektronischen Baugruppe (18) gekoppelt ist.

10. Einschubgerät (10) nach Anspruch 9,
**dadurch gekennzeichnet,**
**dass** die Leiterplatte (62) formschlüssig an der Bodenplatte (30) und/oder an der Deckelplatte (28) gehalten ist.

11. Einschubgerät (10) nach Anspruch 9 oder 10,
**dadurch gekennzeichnet,**
**dass** die erste elektronische Baugruppe (16) und/oder die zweite elektronische Baugruppe (18) entlang einer parallel zu einer Seitenplattennormalen (S) orientierten Montagerichtung mit der Leiterplatte (62) mechanisch lösbar gefügt sind.

12. Baugruppenträger (2) mit einem Einschubfach (8), in welches ein Einschubgerät (10) nach einem der Ansprüche 1 bis 11 aufgenommen ist.
